(19) Europäisches Patentamt
European Patent Office
Office européen des brevets

(11) **EP 4 776 495 A1**

(12) **EUROPEAN PATENT APPLICATION**

(43) Date of publication:
**15.07.2026 Bulletin 2026/29**

(51) International Patent Classification (IPC):
**H02M 1/12** *(2006.01)* **H02M 1/15** *(2006.01)*

(21) Application number: **25151538.3**

(52) Cooperative Patent Classification (CPC):
**H02M 1/12;** H02M 1/15

(22) Date of filing: **13.01.2025**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ETEL S.A.**
**2112 Môtiers (CH)**

(72) Inventors:
• **Gualco, Gabriele**
**1534 Sassel (CH)**
• **Erb, Carole**
**2108 Couvet (CH)**

• **Hirsig, Pierre**
**2000 Neuchâtel (CH)**
• **Savy, Cyrille**
**2024 Saint-Aubin-Sauges (CH)**
• **Tissot, Eric**
**25300 Les Fourgs (FR)**
• **Pfister, Daniel**
**2112 Môtiers (CH)**
• **Matthey-Doret, Gaëtan**
**2114 Fleurier (CH)**
• **Tedesco, Raffaele**
**2300 La Chaux-de-Fonds (CH)**

(74) Representative: **P&TS SA (AG, Ltd.)**
**Avenue J.-J. Rousseau 4**
**P.O. Box 2848**
**2001 Neuchâtel (CH)**

(54) **LOW-PASS ACTIVE FILTER FOR A MOTOR-DRIVING PWM SIGNAL**

(57) The present invention relates to a low-pass active filter (10) for a motor-driving PWM signal generated by a power inverter (30) in an electric motor drive. The active filter (10) comprises a first transformer (12) having a primary winding $(L_1)$ and a secondary winding $(L_2)$, a first low-pass passive filtering circuit (14) arranged to filter the output signal of said primary winding $(L_1)$ in order to power the electric motor, a current sensor (16) for measuring a current $(I_p)$ flowing in the active filter (10) and an amplifier (18) configured to generate and inject a compensating current $(I_s)$ into said secondary winding $(L_2)$.

The compensating current $(I_s)$ is the current $(I_p)$ measured by the current sensor (16) multiplied by the gain of the amplifier (18). The primary winding $(L_1)$ of the first transformer (12) is the inductor component of the filtering circuit (14). The gain of the amplifier (18) is determined such that said compensating current $(I_s)$ is adapted to counteract the high-frequency PWM voltage component in the motor-driving PWM signal through the mutual inductance of said first transformer (12) in order to at least attenuate ripple in said signal.

**Fig.1**

EP 4 776 495 A1

## Description

## Technical domain

The present invention concerns a low-pass active filter for a PWM signal for driving an electric motor such as a synchronous or a DC motor. The invention also concerns a linear electric motor comprising the low-pass active filter as well as an X-Y positioning stage for a semiconductor equipment, such as a photolithography machine or a wafer inspection system, comprising several linear electric motors equipped with the low-pass active filter.

## Background art

Inverters or Class-D amplifiers conventionally used to drive electric motors have now reached precision levels comparable to those of linear amplifiers. However, despite this improved precision, they still produce unwanted electrical disturbances at the PWM frequency since such PWM frequency introduces ripple in the motor's current and voltage waveform which causes force fluctuations when the electric motor is operating. These force fluctuations may cause oscillations in the motor's mover leading to mechanical vibrations of the load, thereby causing positioning errors which may have a significant negative impact for high precision positioning machines used in the semiconductor industry.

To address unwanted ripple, various solutions have been proposed in the literature, including the use of hybrid linear/Class-D amplifiers and passive filters, such as disclosed in EP0682401B1.

Hybrid linear/Class-D amplifiers such as disclosed in EP2388910B1 and US6396933B1 can completely suppress these unwanted disturbances, but their use is limited to low-voltage applications, around 100 V, where linear amplifiers can be effectively designed. Hybrid linear/Class-D amplifiers are therefore not adapted in the context of motor drives for electric motors used in semiconductor positioning systems where a voltage well above 200 Volts, for example 300 or even 600 Volts, is usually required.

In a typical Class-D amplifier employed as a motor inverter, the high-voltage square wave output directly powers the motor. However, as noted earlier, the high-voltage PWM signals can introduce unacceptable levels of electromagnetic disturbance to sensitive high-precision measurement equipment. These disturbances can be mitigated to acceptable levels through the implementation of passive filters such as the RLC low pass filter to achieve the desired attenuation at the specified disturbance frequency.

The use of larger inductance values can help achieve a smoother voltage output since it better resists rapid changes in current, filtering out more high-frequency components of the motor driving PWM signal. Yet, larger inductance values often require physically larger components which can exceed the available space. In addition, the inductor must avoid saturation across the entire operating current range, which complicates achieving high inductance values. A multi-stage filter design is often a better alternative, although it may still result in substantial device size which is not adapted in case of volume limitations.

## Short disclosure of the invention

An aim of the present invention is therefore to provide a low-pass active filter for a motor-driving PWM signal that addresses the above-limitations.

More particularly, an aim of the present invention is to provide a low-pass active filter for a motor-driving PWM signal comprising an improved ratio of filter size to filtering performance.

Another aim of the present invention is to provide a linear electric motor, such as a synchronous motor wherein the mover is made of coils powered by a DC voltage.

A further aim of the present invention is to provide a X-Y positioning stage with a positioning accuracy at the nanometre or sub-nanometre level.

According to the invention, these aims are achieved by the object of the attached claims, and especially by a low-pass active filter for a motor-driving PWM signal generated by a power inverter in an electric motor drive. The active filter comprises a first transformer having a primary winding and a secondary winding, a first low-pass passive filtering circuit arranged to filter the output signal of said primary winding in order to power the electric motor, a current sensor for measuring a current flowing on the active filter and an amplifier configured to generate and inject a compensating current into said secondary winding. The compensating current is the current measured by the current sensor multiplied by the gain of the amplifier. The primary winding of the first transformer is the inductor component of the first low-pass passive filtering circuit. The gain of the amplifier is determined such that said compensating current is adapted to counteract the high-frequency PWM voltage component in the motor-driving PWM signal through the mutual inductance of said first transformer in order to at least attenuate ripple in said signal.

In an embodiment, the low-pass active filter further comprises a high-pass filter to extract high-frequency components of the output signal of the power inverter from the compensating current before the injection of said compensating current into said secondary winding.

In an embodiment, the high-pass filter is arranged between the current sensor and the amplifier.

In an embodiment, the current sensor is arranged on the input side or on the output side of the primary winding of the first transformer.

In an embodiment, the current sensor is arranged to measure current flowing in the RC branch of said first low-pass passive filtering circuit.

In an embodiment, the current sensor is a second transformer having a primary winding and a secondary winding. The output of the primary winding is connected to an input of the primary winding of the first transformer. The amplifier inputs are connected to the terminals of the secondary winding of the second transformer. The output of the amplifier is injected into the secondary winding of the first transformer.

In an embodiment, the amplifier is an operational transconductance amplifier (OTA), a linear amplifier or a class-D amplifier.

In an embodiment, the low-pass active filter further comprises a second low-pass passive filtering circuit arranged to be connected to the output of the inverter and to filter out the PWM signal before measurement of the current by the sensor current.

In an embodiment, the first low-pass passive filtering circuit comprises at least a capacitance and a resistance in series arranged in parallel with said inductor component.

In an embodiment, the first low-pass passive filtering circuit further comprises another inductor arranged in series with said resistance and capacitance.

In an embodiment, the output of the secondary winding of the first transformer is connected to ground.

Another aspect of the invention relates to a motor drive comprising at least one power inverter and at least one low-pass active filter, according to any of the above embodiments, to filter out the output of the power inverter.

Another aspect of the invention relates to an electric motor, in particular a synchronous motor, comprising the above motor drive.

Another aspect of the invention relates to a X-Y positioning stage for a semiconductor processing equipment, in particular a photolithography machine or a wafer inspection system, comprising one or more of the above electric motor.

**Short description of the drawings**

Exemplar embodiments of the invention are disclosed in the description and illustrated by the drawings in which:

- Figure 1 is an electrical diagram of a low-pass active filter for filtering out the PWM component of a PWM signal, according to an embodiment,

- Figure 2 is an electric diagram of the passive filtering circuit of the low-pass active filter of Figure 1,

- Figure 3 is an electric diagram of a passive filtering circuit of the low-pass active filter according to another embodiment,

- Figures 4 and 5 are partial electric diagrams of the low pass active filter with other arrangements of the current sensor, according to other embodiments,

- Figure 6 illustrates a block diagram of a low-pass active filter, similar to the low-pass active filter of Figure 1, further comprising a high-pass filter to extract high-frequency components of the output signal of the power inverter,

- Figure 7 is an electric diagram of the low-pass active filter comprising an OTA with a feedback loop according to another embodiment,

- Figure 8 is an electric diagram the low-pass active filter comprising a second transformer for current measurement and an OTA connected to the terminal of the secondary winding of this second transformer according to another embodiment,

- Figure 9 is an electric diagram of the low-pass active filter comprising an additional filtering circuit connected to the output of the inverter, according to another embodiment, and

- Figure 10 is a simulation of the low-pass active filter showing a 300V PWM voltage at the input of the active filter and the residual 200mV PWM voltage at the output of the filter.

**Examples of embodiments of the present invention**

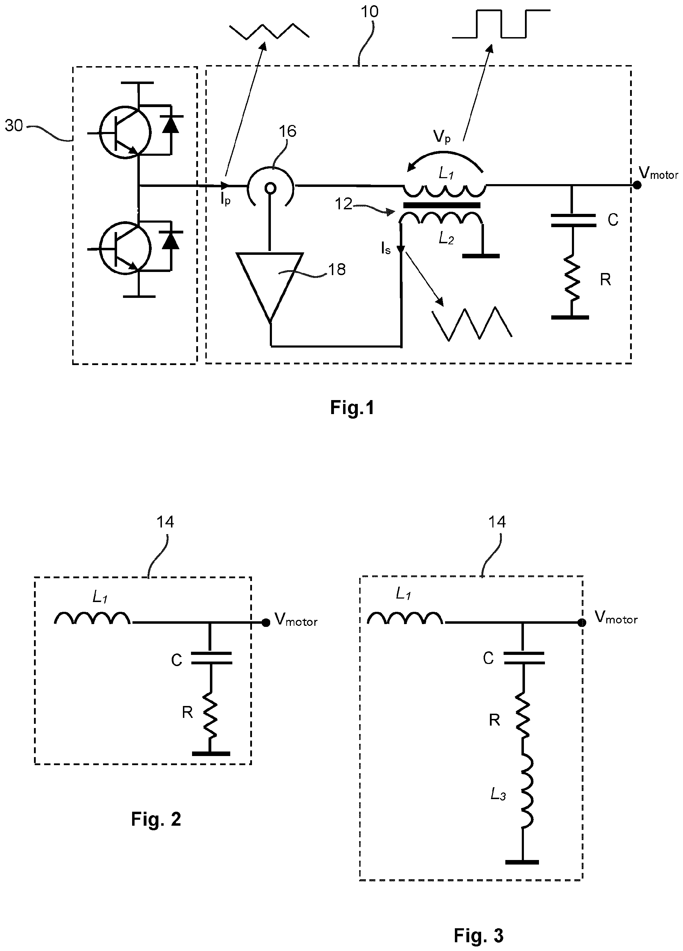

With reference to figure 1, the low-pass active filter 10 is arranged to filter out Pulse Width Modulated (PWM) signal generated by the power inverter 30. A Class-D amplifier can be used as power inverter to generate PWM signals. In this respect, a PWM generator (not represented) comprises a carrier generator configured to generate a carrier. The carrier is fed into a comparator together with a reference signal to output a PWM signal which is fed to the gate drivers of the Class D amplifier.

The low-pass active filter 10 comprises a transformer 12 having a primary winding $L_1$ and a secondary winding $L_2$. The primary winding $L_1$ of the transformer 12 forms together with the capacitance C and the resistance R a low-pass passive filtering circuit 14, as shown in Figure 2, arranged to filter out or at least mitigate the ripple of the output signal $V_{motor}$ so as to improve motor performance by reducing vibration, heating and noise while increasing efficiency and control. The primary winding $L_1$ of the first transformer 12 acts as the inductor component of the low-pass passive filtering circuit 14.

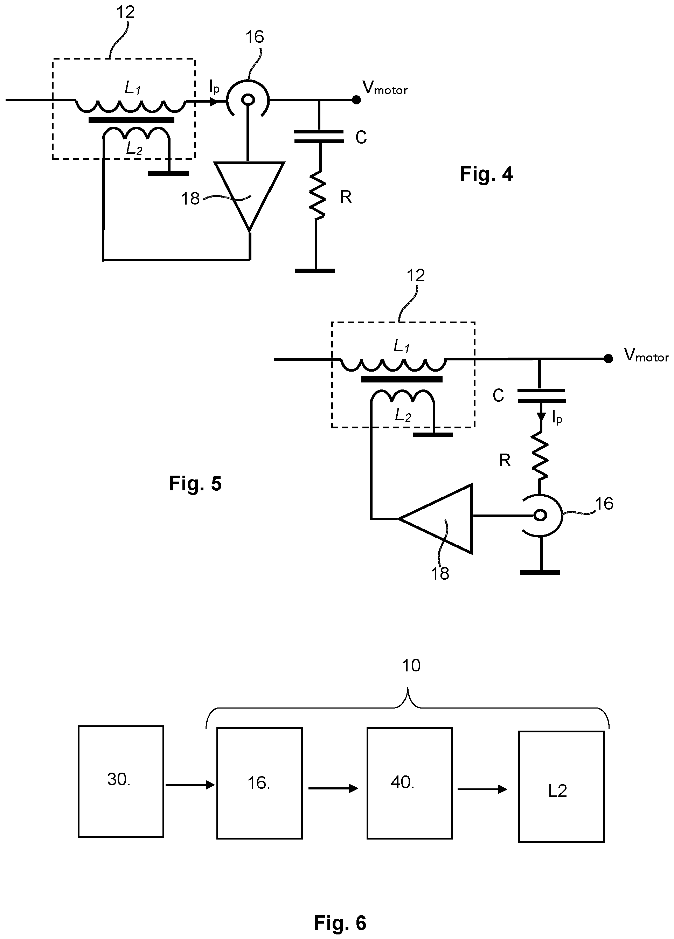

The low-pass active filter 10 further comprises a current sensor 16 for measuring a current $I_p$ output by the inverter 30 (e.g. Class-D amplifier) of a triangular waveform. The current sensor 16 may be arranged at a different location to measure the current $I_p$. In the embodiment of Figure 1, the current sensor 16 is arranged to measure the current $I_p$ flowing on the input side of the primary

winding $L_1$ of the transformer 12. In another embodiment shown in Figure 4, the current sensor 16 of the low-pass active filter is arranged to measure the current $I_p$ flowing on the output side of the primary winding $L_1$ of the transformer 12. In yet another embodiment shown in Figure 5, the current sensor 16 is arranged to measure current flowing in the RC branch of the low-pass passive filtering circuit. The current may be measured for example with a shunt resistance or with a second transformer as described below.

With reference to Figure 1, the low-pass active filter 10 also comprises an amplifier 18 configured to generate and inject a compensating current $I_s$ into the secondary winding $L_2$ of the transformer 12. The compensating current $I_s$ is a replica of the triangle waveform of the current $I_p$ output by the inverter 30 with a typically greater amplitude. The required amplitude can be tuned when selecting the number of turns of the transformer windings. The amplifier may be a linear amplifier, a class-D amplifier or an operational transconductance amplifier (OTA), as described subsequently.

With reference to Figure 6, the low-pass active filter 10 may further comprise a high-pass filter 40 to extract high-frequency components of the output signal of the power inverter 30 from the compensating current before the injection of the latter into the secondary winding $L_2$ of the transformer 12. The high-pass filter 40 is used to remove low-frequency components that may be present in the PWM signal, in particular the low-frequency sinusoidal voltages used to control the motor. These low frequency components of the PWM signal are not part of the portion of the signal which needs to be cancelled or at least mitigated at the output of the low-pass active filter 10.

According to an ideal scenario, a steady state PWM signal output from the inverter, in case of a perfect filter, would result in a DC voltage on the output $V_{motor}$. This means that the entire voltage drop occurs across the transformer primary winding $L_1$ which is the inductor component of the low-pass passive filtering circuit 14. The inductance is defined as the ratio of the induced voltage to the rate of change of current causing it, as expressed by the following formula:

$$L = \frac{V}{\frac{di}{dt}} \rightarrow V = L\frac{di}{dt}$$

Accordingly, in order to have a sufficient voltage drop across the transformer primary winding $L_1$, larger coils may be used to increase the inductance. However, as previously mentioned, the use of large coils to filter effectively the PWM components of the motor-driving signal in order to mitigate the signal ripple is not always a viable option when facing volume limitations.

Yet, the relationship between inductance and flux for a coil can be understood by considering that the magnetic flux $\phi$ is proportional to the current I in the coil and the number of turns N. Therefore, the inductance can be expressed as:

$$L = \frac{N^2 \Phi}{i}$$

Consequently, for boosting the inductance of a coil, it is possible to boost the magnetic flux that is generated by a driving current. In order to boost such magnetic flux, the current $I_p$ at the output of the inverter 30 is first multiplied by the gain of the amplifier 18 to generate the compensating current $I_s$ of a predetermined value. The compensating current is then injected in the transformer secondary winding $L_2$ to counteract the high-frequency PWM voltage component in the motor-driving PWM signal through the mutual inductance of the transformer 12 in order to at least attenuate the ripple in the signal.

The current $I_s$ flowing in the secondary winding $L_2$ of the transformer 12 can therefore be expressed by the formula:

$$I_s = \beta \cdot \text{HF}\big(I_p\big)$$

where $\beta$ is the gain of the amplifier 18 and HF (Ip) is the high-frequency components of the signal at the output of the power inverter 30.

The voltage drop $V_p$ across the primary winding $L_1$ of the transformer is defined by the formula:

$$V_p = L_{12} \cdot \frac{dI_s}{dt}$$

The mutual inductance $L_{12}$ of the transformer 12 therefore increases the voltage drop $V_p$. Given that the rate of change of the current $I_p$ is directly proportional to the voltage $V_p$, a larger voltage across the transformer primary winding $L_1$ causes a steeper slope in the current waveform during the portions of the triangular signal where the voltage is constant. To minimize signal ripple as much as possible, the voltage across $V_p$ must closely resemble a perfect square waveform as shown in Figure 1.

The combination of the transformer primary winding $L_1$ and the capacitor C of the low-pass passive filter 14 filters out the high-frequency components of the square wave, leaving only the low-frequency or DC component at the output. The values of the capacitance C and of the resistance R of the RC circuit are chosen to have a large time constant to have a slower response and smoother filtering of high-frequency components of the signal such that the $V_{motor}$ is as constant as possible.

The number of turns in the primary and secondary windings $L_1$, $L_2$ of the transformer 12, along with the amplifier's gain, can be selected based on the magnitude of the ripple that needs to be filtered to output a DC voltage to drive the electric motor. The transformer 12 may be dimensioned to bear the 30A foreseen peak current on the primary side with no saturation. The primary and secondary winding $L_1$, $L_2$ of the transformer may comprise for example 11 turns and 4 turns respectively.

The low-pass filtering circuit 14 may comprise a capacitance C and a resistance R in series and arranged in parallel with the primary winding $L_1$ of the transformer 12 which is the inductor component of the filtering circuit as shown in Figure 2.

In another embodiment, the low-pass filtering circuit 14 may comprise an additional inductance $L_3$ mounted in series with the capacitance C and the resistance R as shown in Figure 3 to have a second-order low-pass filter with a steeper attenuation slope

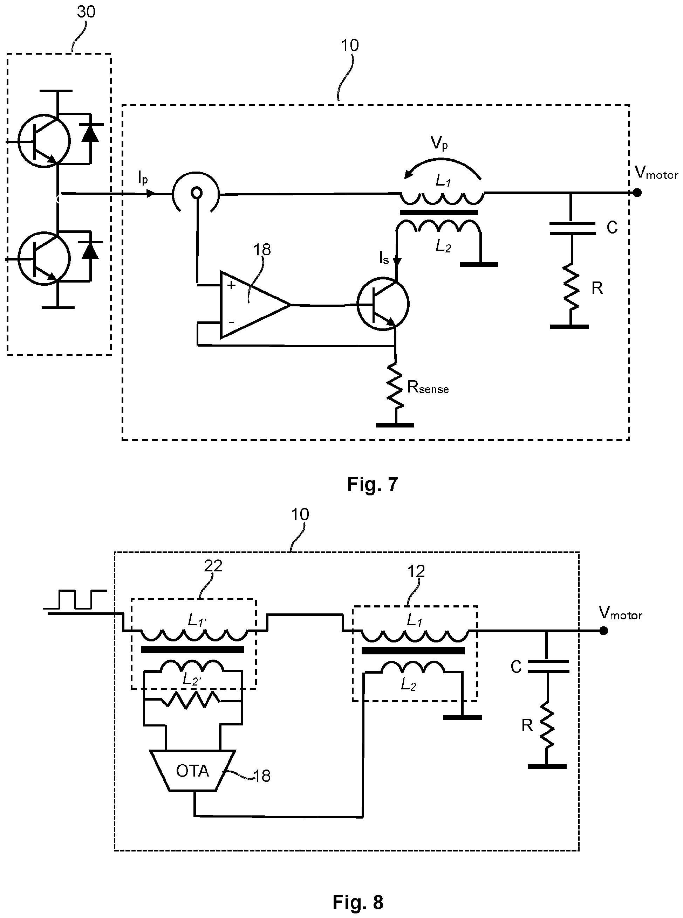

In another embodiment shown in Figure 7, the low-pass active filter comprises an OTA 18 with a feedback loop. The resistance $R_{sense}$ is used to set the V-I current gain. This adds more precision with respect to an open loop OTA implementation as the feedback back loop allows to set precisely the amplifier gain.

In another embodiment shown in Figure 8, the low-pass active filter 10 comprises a second transformer 22 having a primary winding $L_{1'}$ and a secondary winding $L_{2'}$. The output of the primary winding $L_{1'}$ of this second transformer 22 is connected to an input of the primary winding $L_1$ of the first transformer 12. An operational transconductance amplifier (OTA) 18 is used with its inputs connected to the terminals of the secondary winding $L_{2'}$ of the second transformer 22 while the output of the amplifier 18 is injected into the secondary winding $L_2$ of the first transformer 12.

The OTA is preferred over a classical operational amplifier since a controlled current source is required for limiting the phase delay in the injected current with regard to the phase of the fundamental frequency of the current $I_p$ in the primary winding $L_1$ of the first transformer 12. In fact, a small as possible delay as well as high enough current drive capability at the frequency of interest must be guaranteed. The injection transformer is the element where the flux is boosted. The winding turns ratio on primary and secondary windings can be selected according to the active part requirement.

In this embodiment, the current measurement is performed via the second transformer since the secondary winding, with many turns, produces a reduced current proportional to the primary current. Using a transformer for current measurement allows to add a natural high-pass filter, limit the loop delay and to naturally isolate the primary side to the secondary side.

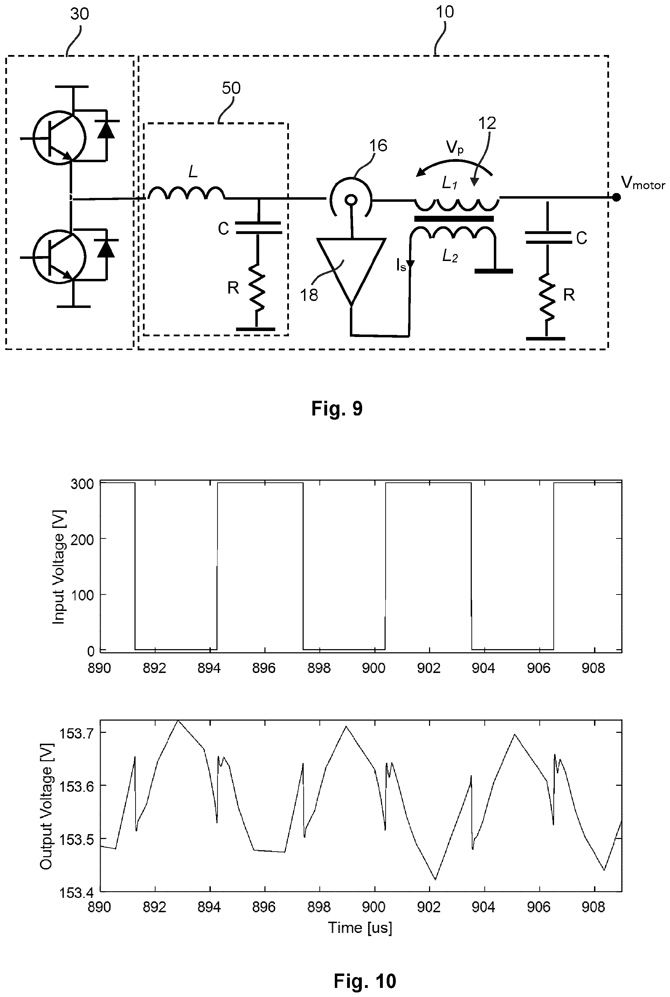

In another embodiment shown in Figure 9, the low-pass active filter 10 further comprises a second low-pass passive filtering circuit 50 arranged to be connected to the output of the inverter 30 and to filter out the PWM signal before measurement of the current by the sensor current 16. This second low-pass passive filtering circuit 50 may be added to any of the above-described embodiments and may be for example of the type of a RLC filter.

Figure 10 is a simulation of the low-pass active filter 10 showing a 300V PWM voltage at the input of the active filter and a residual 200mV PWM voltage at the output of the filter for a switching PWM frequency of 160 kHz.

The low-pass active filter, as described in the appended claims, is primarily used in linear motors, especially synchronous motors in which the mover's coils are powered by a DC voltage. These linear motors are particularly suited for X-Y positioning stages in the semiconductor industry, such as in photolithography machines and wafer inspection systems, where positioning accuracy at the nanometre or sub-nanometre level is essential.

**Claims**

1. A low-pass active filter (10) for a motor-driving PWM signal generated by a power inverter (30) in an electric motor drive, the active filter (10) comprising a first transformer (12) having a primary winding ($L_1$) and a secondary winding ($L_2$), a first low-pass passive filtering circuit (14) arranged to filter the output signal of said primary winding ($L_1$) in order to power the electric motor, a current sensor (16) for measuring a current ($I_p$) flowing on the low-pass active filter (10) and an amplifier (18) configured to generate and inject a compensating current ($I_s$) into said secondary winding ($L_2$), wherein said compensating current ($I_s$) is the current ($I_p$) measured by the current sensor (16) multiplied by the gain of the amplifier (18), wherein the primary winding ($L_1$) of the first transformer (12) is the inductor component of the first low-pass passive filtering circuit (14) and wherein the gain of the amplifier (18) is determined such that said compensating current ($I_s$) is adapted to counteract the high-frequency PWM voltage component in the motor-driving PWM signal through the mutual inductance of said first transformer (12) in order to at least attenuate ripple in said signal.

2. The low-pass active filter (10) according to claim 1, further comprising a high-pass filter (40) to extract high-frequency components of the output signal of the power inverter (30) from the compensating current ($I_s$) before the injection of said compensating current ($I_s$) into said secondary winding ($L_2$).

3. The low-pass active filter (10) according to the preceding claim, wherein the high pass-filer (40) is arranged between the current sensor (16) and the amplifier (18).

4. The low-pass active filter (10) according to any preceding claim, wherein the current sensor (16) is arranged on the input side or on the output side of said primary winding ($L_1$).

5. The low-pass active filter (10) according to the preceding claim, wherein the current sensor (16) is arranged to measure current flowing in the RC branch of said first low-pass passive filtering circuit (14).

6. The low-pass active filter (10) according to any preceding claim, wherein the current sensor (16) is a second transformer (22) having a primary winding ($L_1'$) and a secondary winding ($L_2'$), wherein the output of said primary winding ($L_1'$) is connected to an input of the primary winding of the first transformer (12), wherein the amplifier (18) inputs are connected to the terminals of the secondary winding ($L_2'$) of said second transformer (22) and wherein the output of said amplifier (18) is injected into the secondary winding ($L_2$) of the first transformer (12).

7. The low-pass active filter (10) according to any preceding claim, wherein said amplifier (18) is an operational transconductance amplifier (OTA), a linear amplifier or a class-D amplifier.

8. The low-pass active filter (10) according to any preceding claim, further comprising a second low-pass passive filtering circuit (50) arranged to be connected to the output of the inverter (30) and to filter out the PWM signal before measurement of the current by the sensor current (16).

9. The low-pass active filter (10) according to any preceding claim, wherein said first low-pass passive filtering circuit (14) comprises at least a capacitance (C) and a resistance (R) in series and arranged in parallel with said inductor component ($L_1$).

10. The low-pass active filter (10) according to the preceding claim, wherein said first low-pass passive filtering circuit (14) further comprises another inductor ($L_3$) arranged in series with said resistance (R) and capacitance (C).

11. The low-pass active filter (10) according to any preceding claim, wherein the output of the secondary winding ($L_2$) of the first transformer (12) is connected to ground.

12. A motor drive comprising at least one power inverter (30) and at least one low-pass active filter (10), according to any preceding claim, to filter out the output of said power inverter.

13. An electric motor, in particular a synchronous motor, comprising the motor drive according to the preceding claim to drive the coils of the mover of the motor.

14. An X-Y positioning stage for a semiconductor processing equipment, in particular a photolithography machine or a wafer inspection system, comprising one or more electric motors according to the preceding claim.

**Fig.1**

**Fig. 2**

**Fig. 3**

12

$L_1$

$L_2$

16

$I_p$

$V_{motor}$

C

R

18

**Fig. 4**

12

$L_1$

$L_2$

C

$I_p$

$V_{motor}$

R

18

16

**Fig. 5**

10

30.  →  16.  →  40.  →  L2

**Fig. 6**

**Fig. 7**

**Fig. 8**

**Fig. 9**

**Fig. 10**

Europäisches
Patentamt

European
Patent Office

Office européen
des brevets

# EUROPEAN SEARCH REPORT

**Application Number**

EP 25 15 1538

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/010506 A1 (SAKAI TAKUYA [JP] ET AL) 10 January 2013 (2013-01-10) * paragraphs [0002], [0022] - [0026], [0033], [0043], [0044]; figures 1,5,9 * ----- | 1-14 | INV. H02M1/12 H02M1/15 |
| X | US 2021/313873 A1 (YAMAMOTO YUSHIN [JP] ET AL) 7 October 2021 (2021-10-07) * paragraphs [0003], [0009], [0065], [0084], [0085]; figure 2 * ----- | 1 | |
| X | US 10 700 616 B2 (UNIV HOKKAIDO NAT UNIV CORP [JP] ET AL.) 30 June 2020 (2020-06-30) * column 5, lines 13-26; figure 3 * ----- | 1 | |

**TECHNICAL FIELDS SEARCHED (IPC)**

H02M

The present search report has been drawn up for all claims

| Place of search | Date of completion of the search | Examiner |
|---|---|---|
| The Hague | 4 June 2025 | Gusia, Sorin |

EPO FORM 1503 03.82 (P04C01)

## ANNEX TO THE EUROPEAN SEARCH REPORT
## ON EUROPEAN PATENT APPLICATION NO.

EP 25 15 1538

This annex lists the patent family members relating to the patent documents cited in the above-mentioned European search report.
The members are as contained in the European Patent Office EDP file on
The European Patent Office is in no way liable for these particulars which are merely given for the purpose of information.

04-06-2025

| Patent document cited in search report | | Publication date | Patent family member(s) | | Publication date |
|---|---|---|---|---|---|
| US 2013010506 | A1 | 10-01-2013 | CN | 102844975 A | 26-12-2012 |
| | | | DE | 112011101193 T5 | 17-01-2013 |
| | | | JP | 5528543 B2 | 25-06-2014 |
| | | | JP | WO2011125944 A1 | 11-07-2013 |
| | | | US | 2013010506 A1 | 10-01-2013 |
| | | | WO | 2011125944 A1 | 13-10-2011 |
| US 2021313873 | A1 | 07-10-2021 | CA | 3103081 A1 | 10-09-2020 |
| | | | CN | 112514241 A | 16-03-2021 |
| | | | EP | 3937364 A1 | 12-01-2022 |
| | | | JP | 6803478 B1 | 23-12-2020 |
| | | | JP | WO2020179064 A1 | 18-03-2021 |
| | | | KR | 20210024125 A | 04-03-2021 |
| | | | US | 2021313873 A1 | 07-10-2021 |
| | | | WO | 2020179064 A1 | 10-09-2020 |
| US 10700616 | B2 | 30-06-2020 | CA | 3001121 A1 | 11-05-2017 |
| | | | CN | 108377666 A | 07-08-2018 |
| | | | EP | 3373437 A1 | 12-09-2018 |
| | | | JP | 6491349 B2 | 27-03-2019 |
| | | | JP | WO2017077939 A1 | 16-08-2018 |
| | | | KR | 20180059907 A | 05-06-2018 |
| | | | US | 2018278176 A1 | 27-09-2018 |
| | | | WO | 2017077939 A1 | 11-05-2017 |

For more details about this annex : see Official Journal of the European Patent Office, No. 12/82

**EP 4 776 495 A1**

**Patent documents cited in the description**

- EP 0682401 B1
- EP 2388910 B1

- US 6396933 B1